# EUROPÄISCHE PATENTSCHRIFT

(11) **EP 0 710 429 B1**
(45) Veröffentlichungstag und Bekanntmachung des Hinweises auf die Patenterteilung: **23.06.1999**
(21) Anmeldenummer: 94920881.3
(22) Anmeldetag: 13.07.1994
(51) Int. Cl.: H05H 1/46, H01J 37/32

(54) **VERFAHREN ZUR ANPASSUNG DES GENERATORS BEI BIPOLAREN NIEDERDRUCK-GLIMMPROZESSEN**
METHOD FOR MATCHING THE GENERATOR IN DIPOLAR LOW-PRESSURE GLOW PROCESSES
PROCEDE PERMETTANT D'ADAPTER LE GENERATEUR DANS DES PROCESSUS BIPOLAIRES DE DECHARGE PAR EFFLUVES BASSE PRESSION

(30) Priorität: 22.07.1993 DE 4324683
(43) Veröffentlichungstag der Anmeldung: 08.05.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: KIRCHHOFF, Volker, D-01324 Dresden (DE); RESCHKE, Jonathan, D-01067 Dresden (DE); SCHILLER, Siegfried, D-01324 Dresden (DE); GOEDICKE, Klaus, D-01307 Dresden (DE)
(86) Internationale Anmeldenummer: DE9400817
(87) Internationale Veröffentlichungsnummer: WO9503682

(56) Entgegenhaltungen:
- EP-A- 0 359 966
- DE-A- 2 435 023
- DE-A- 3 514 690
- US-A- 4 357 195
- US-A- 4 500 563
- US-A- 5 082 546
- REVIEW OF SCIENTIFIC INSTRUMENTS., Bd.61, Nr.9, September 1990, NEW YORK US Seiten 2401 - 2406, XP161795 GODYAK ET AL. 'An experimental system for symmetric capacitive rf discharge studies'

## Beschreibung

Die Erfindung betrifft ein Verfahren zur Durchführung bipolarer Niederdruck-Glimmprozesse, sowohl bei asymmetrischem als auch bei weitestgehend symmetrischem Aufbau der Prozeßeinrichtung. Dieses Verfahren wird bei der Plasmabehandlung von Oberflächen, der Abscheidung von Schichten aus dem Plasma und der plasmagestützten Oberflächenreinigung angewendet. Es ist insbesondere geeignet bei der Verwendung von Reaktivgasen zur Abscheidung von Verbindungsschichten. Derartige Prozesse dienen vorzugsweise zur Oberflächenveredelung von Bauteilen, Werkzeugen, Halbzeugen und Fertigteilen in der Optik, im Maschinenbau, in der Verpackungs-, Glas- und Elektroindustrie.

Es sind eine Vielzahl von Verfahren zur Anpassung der Energieeinspeisung an den bipolaren Niederdruck-Glimmprozeß bekannt. Dabei wird die Energie in Form einer Wechselspannung den beiden Elektroden des Niederdruckprozesses zugeführt. Bedingt durch nicht zu vermeidende Unterschiede der beiden Elektroden hinsichtlich der Geometrie, der Prozeßraumumgebung, der Magnetfeldeinflüsse, der Restgaszusammensetzung, der Elektrodenbedeckung, des Elektrodenabtrages usw. hängt die Strom-Spannungskennlinie der Glimmentladung von der Polung ab. Bei vielen Anwendungen kann dieser Unterschied nicht toleriert werden, so daß eine Anpassung erforderlich ist. Häufig wird hierbei eine Symmetrierung verlangt. Bei verschiedenen Anwendungen, wie z. B. bei der Herstellung spezieller Schichtzusammensetzungen, werden jedoch definierte Unterschiede der Glimmparameter beider Elektroden bzw. Targets gefordert. Dazu ist es besonders notwendig, in Abhängigkeit von den Prozeßparametern, die polungsabhängig die Energieeinspeisung in die Targets und damit die Zerstäubungsrate getrennt zu steuern.

Es ist bekannt, bipolare Rechteckgeneratoren einzusetzen, um diese notwendigen Anpassungen einfach durchführen zu können. Bei Verwendung dieser Technik ist es möglich, die Pulsform (bezügl. der Spannung, des Stromes, der Pulslänge oder der Leistung) für den positiven und negativen Impuls getrennt einzustellen und gegebenenfalls zu steuern (G. Mark, T. Linz; "Mit bipolarem Pulsplasma in eine neue Plasmaaera"; Dünne Schichten, 1992, H 4, S. 13-15). Ein Nachteil besteht darin, daß die Pulsgeneratoren eine technische Grenze in bezug auf die Generatorleistung, die Pulsspannung und dic Pulsfrequenz besitzen. Besonders bei größeren Generatorleistungen sind Pulsfrequenzen über 30 kHz, bedingt durch die notwendige Steilheit der Schaltflanken, nicht realisierbar.

Weiterhin sind für kleinere Generatorleistungen (0,5 bis einige kW) HF-Generatoren auf der Basis von Halbleiterschaltern bekannt (DE 39 42 560 A 1). Aufgrund der verfügbaren Halbleiterbauelemente sind die angegebenen notwendigen Schaltzeiten von 1 bis 5 ns nur bei den angegebenen kleinen Leistungen und bei kleinen Spannungen erreichbar.

Weiterhin ist bekannt, zur periodischen Speisung elektrische, kapazitive Anteile enthaltender Lasten (wie z. B. Laser), einzelne Spannungs- bzw. Stromimpulse mittels eines Schwingkreises zu erzeugen. Dabei ist die kapazitive Last Bestandteil des Schwingkreises (DE 41 12 161 A 1). Diese Schaltung gestattet nur die Steuerung der eingespeisten Gesamtenergie in die Plasmastrecke und ist damit für eine Symmetrierung innerhalb der Plasmastrecke nicht geeignet.

Es ist bekannt, bei HF-Plasmaprozessen die Voreinstellung des "Self-Bias"-Potentials durch Einspeisung der Energie mit unterschiedlichen Frequenzen an der jeweiligen Elektrode vorzunehmen (US 5,110,438). Dieses Verfahren ist nur für isolierende Materialien und bei Generatorfrequenzen oberhalb einiger MHz wirksam, da sich nur unter diesen Bedingungen ein wirksames "Self-Bias"-Potential ausbildet.

Es ist weiterhin bekannt, zur Energieerzeugung für den bipolaren Glimmprozeß Sinusgeneratoren einzusetzen. Besonders beim Einsatz dieser bipolaren Glimmeinrichtung zur reaktiven Abscheidung von Oxiden hat die Pulsfrequenz einen großen Einfluß auf die Schichtqualität, insbesondere auf die Defektdichte. Um solche Schichten mit geringer Defektdichte herstellen zu können, muß man in einem Frequenzbereich über 50 kHz bis ca. 200 kHz arbeiten, der nur mit Hilfe von Sinusgeneratoren erreicht wird. Große Probleme bereitet hierbei aber die Anpassung an die Glimmeinrichtung. Besonders bei großen bipolaren Glimmeinrichtungen für Großflächenbeschichtung sind hohe Generatorleistungen erforderlich. Für diese Leistungen im Bereich von 10 kW bis 200 kW gibt es zur Zeit keine brauchbaren Lösungen für eine effektive Anpassung. Für kleine Leistungen ist es bekannt, mit Hilfe einer komplizierten Kondensatorbeschaltung und einer Zusatzelektrode eine Anpassung für eine reaktive Beschichtung durch Sputtern mit bipolarer Glimmeinrichtung durchzuführen (DE 40 42 287 A1). Der Nachteil dieses Verfahrens und Vorrichtung besteht darin, daß die Kondensatorbeschaltung der Impedanz der Glimmeinrichtung möglichst genau angepaßt werden muß, da es keine Stellmöglichkeit gibt. Die Impetanz der Glimmeinrichtung ist aber unter anderem sehr stark vom Reaktivgasfluß abhängig, so daß diese Anpassung nur für einen begrenzten Arbeitsbereich wirksam ist. Eine dynamische Anpassung an den jeweiligen Prozeßzustand ist mit dieser Anordnung nicht möglich. Für große Leistungen ist diese Einrichtung auch nicht einsetzbar.

Es ist weiter bekannt, das Plasma einer Gleichstrom Niederdruck-Glimmentladung zu detektieren und zu analysieren und damit bei der reaktiven Beschichtung die Steuerung der Schichtzusammensetzung vorzunehmen (US 4,166,784; US 4,407,709). Dabei wird die Intensität der optischen Emission des Plasmas als Führungsgröße für den Reaktivgasfluß bzw. für die Stromversorgung genutzt. Es ist weiterhin bekannt, bei HFgespeisten Plasmen in-situ den Plasmazustand zu detektieren, in Abhängigkeit von diesem Signal den HF-Generator zu schalten und damit den Plasmaprozeß zu steuern (US 4,263,088) oder den Generator vor einer Zerstörung durch Fehlanpassung zu schützen (DE 41 22 624 A 1). Eine Übertragung dieser Verfahren auf die bipolare Niederdruck-Glimmentladung kann nicht erfolgen, da eine getrennte Steuerung für die positive und negative Halbwelle nicht möglich ist.

Der Erfindung liegt die Aufgabe zugrunde, ein Verfahren für die bipolare Niederdruck-Glimmentladung zu schaffen, das sowohl eine statische als auch eine dynamische Anpassung des Generators an die Elektroden für die positive und negative Polung in einem großen Leistungs- und Frequenzbereich ermöglicht. Die Anpassung muß in Abhängigkeit von einem vorgegebenen Sollwert oder über eine in-situ gemessene Prozeßgröße steuer- und regelbar sein.

Erfindungsgemäß wird die Aufgabe nach den Merkmalen des Anspruches 1 gelöst. Weitere Ausgestaltungen des Verfahrens zeigen die Unteransprüche.

Ein besonderer Vorteil dieses Verfahrens ist die Tatsache, daß die bipolare Glimmeinrichtung in einem großen Frequenzbereich unabhängig von der Generatorleistung sowohl nach einem festen Programm statisch als auch in Abhängigkeit vom Prozeßzustand dynamisch angepaßt werden kann. Erfindungsgemäß werden mittels einer von der Phasenlage abhängigen Steuerung die Halbwellen bzw. Polungen einzeln überwacht, und in Abhängigkeit von dem jeweiligen Sollwert bzw. Prozeßzustand einzeln für mindestens eine der beiden Polungen, d. h. positiven oder negativen Halbwellen, teilweise und/oder vollständig ausgeblendet und damit für den bipolaren Glimmprozeß unwirksam gemacht. Dadurch ist die Anzahl der negativen Halbwellen, d. h. die Zeit des Wirkens der Energie (Wirkzeit), unterschiedlich zu der Anzahl der positiven Halbwellen.

Besonders vorteilhaft ist es, das Ausblenden einer vollständigen Halbwelle im Nulldurchgang des Stromes bzw. der Spannung durchzuführen. Damit wird ein leistungsloses Schalten ermöglicht, und Störspannungen werden weitestgehend vermieden. Das Ausblenden der jeweiligen Halbwelle kann innerhalb des Generators erfolgen. Es besteht aber auch die Möglichkeit, durch eine zusätzliche Schalteinheit zwischen Generator und bipolarer Glimmeinrichtung die jeweilige Halbwelle zu steuern. Erfolgt das Ausblenden einer vollständigen Halbwelle, ist es zweckmäßig, die Taktfrequenz, mit der die Abschaltung erfolgt, kleiner zu wählen als die Generatorfrequenz. Bei einem Verhältnis der Frequenzen von 1: 10 ist es damit möglich, die Energieverteilung auf die beiden Polungen in 10 % Schritten zu steuern. Es sind aber auch andere Verhältnisse sinnvoll, die eine Steuerung mit einer Genauigkeit bis zu 0,1 Prozentschritten zulassen.

Ein weiterer Vorteil des erfindungsgemäßen Verfahrens besteht darin, daß es unabhängig von der Form der Halbwelle (Pulsform) eingesetzt werden kann. Besonders effektiv ist das Verfahren, bei Verwendung von Sinusgeneratoren für die Glimmstromversorgung.
Eine weitere Ausgestaltung des Verfahrens besteht darin, die Zeit in der die Halbwelle die Energie in dem Glimmprozeß einspeist, durch Vorgabe eines Sollwertes, z. B. Strom oder Spannung oder des Produkts beider Größen, zu steuern. Bei reaktiven Glimmprozessen ist es besonders günstig, diese besagte Zeit direkt in Abhängigkeit von einem Prozeßparameter zu regeln, z. B. der Intensität der optischen Emission des Plasmas, der Beschichtungsrate beim Sputtern oder der Abtragsrate beim Ätzen. Um Spannungsspitzen und undefinierte Zustände innerhalb des Generators beim Steuern einer Halbwelle zu vermeiden, ist es besonders bei großer Generatorleistung zweckmäßig, während besagter Zeit die Energie mittels Kurzschluß oder eines zusätzlichen Verbrauchers abzuleiten. Zur Stabilisierung des Glimmprozesses und zur Reduzierung von unerwünschten Aufladungen innerhalb des Prozeßraumes ist es weiterhin zweckmäßig, während der Ausblendung einer Halbwelle oder Teile einer Halbwelle die Elektroden der Glimmeinrichtung kurzzuschließen. Das Verfahren ist auch für jede Art von Wechselspannung, d. h. die von der Sinusform abweicht, geeignet. An zwei Ausführungsbeispielen wird die Erfindung näher erläutert. In der zugehörigen Zeichnung zeigen:
- Fig. 1:: eine Einrichtung zur reaktiven Beschichtung mit Titan-Aluminium-Nitrid mittels bipolarer Glimmeinrichtung,
- Fig. 1a:: Verlauf der zwischen den Elektroden gemessenen Spannung,
- Fig. 2:: eine Einrichtung zur reaktiven Beschichtung mit Aluminiumoxid mittels bipolarer Glimmeinrichtung,
- Fig. 2a:: Verlauf der zwischen den Elektroden gemessenen Spannung,
- Fig. 2b:: Verlauf der zwischen den Elektroden gemessenen Spannung.

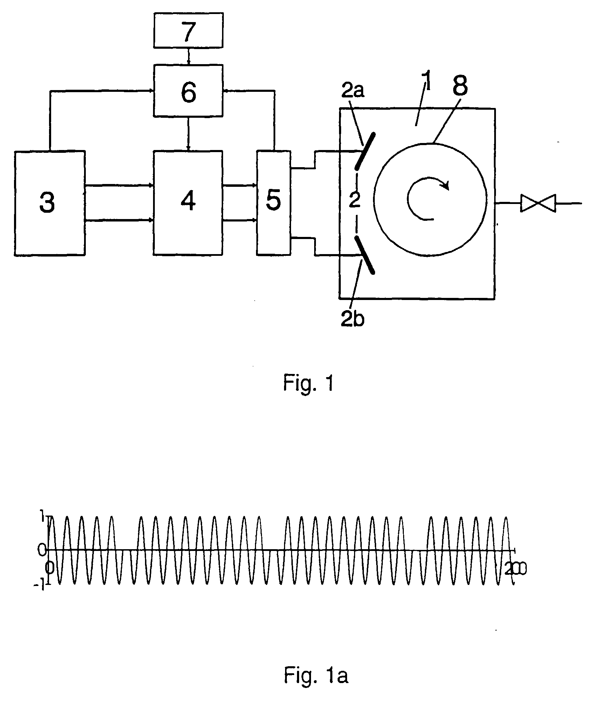

In Fig. 1 befindet sich in einer Vakuumkammer 1 eine bipolare Niederdruck-Glimmeinrichtung 2 mit ihren beiden Elektroden bzw. Targets 2a und 2b, zum Magnetronsputtern, die von einem Sinusgenerator 3 gespeist werden. Das eine Target 2a besteht aus Aluminium und das andere Target 2b aus Titan. In der Vakuumkammer 1 befindet sich ein Argon-Stickstoff-Gemisch bei einem Druck von ca. 0,01 mbar. Der Sinusgenerator 3 hat eine Nennleistung von 70 kW und seine Frequenz kann im Bereich von 40 kHz bis 200 kHz eingestellt werden. Die beiden Elektroden 2a; 2b arbeiten wechselweise als Anode bzw. Katode. Zwischen dem Sinusgenerator 3 und der Glimmeinrichtung 2 sind eine Schalteinheit 4 und ein Sensor 5 zur Strom- und Spannungsmessung angeordnet. Der Sinusgenerator 3 verfügt über einen zusätzlichen Ausgang, über dem die Phasenlage bzw. jeder Nulldurchgang (von Plus nach Minus und von Minus nach Plus) detektiert wird. Dieser Ausgang wird auf eine Steuereinheit 6 geführt, die zusätzlich die Meßwerte des Sensors 5 und die Sollwertvorgabe 7 des Steuerprogramms verarbeitet. Der Sinusgenerator 3 arbeitet bei einer Frequenz von 100 kHz und einer Leistung von 50 kW. Als Sollwerte werden 25 kW pro Elektrode 2a; 2b vorgegeben. Durch die Messung des Stromes und der Spannung mittels des Sensors 5 wird die tatsächlich in die jweilige Elektrode 2a; 2b eingebrachte Leistung bestimmt Diese Daten werden in der Steuereinheit 6 mit dem Sollwert verglichen. Die Steuereinheit 6 liefert Pulse für die Steuerung der Schalteinheit 4, um die entsprechende Halbwelle einer Polung auszublenden. Bei dieser Anordnung ergibt sich eine Taktfrequenz für die Steuerung der positiven Halbwelle von ca. 10 kHz, d. h. es wird ca. jede zehnte positive Halbwelle beim Nulldurchgang fortgeschaltet. Damit wurde die Unsymmetrie zwischen den beiden Elektroden 2a; 2b von ca. 10 % ausgeglichen.
In der Vakuumkammer 1 ist den Elektroden 2a; 2b zugeordnet eine Drehtrommel 8 angeordnet, auf deren Umfang sich die zu beschichtenden Substrate (nicht gezeichnet) befinden.

In Fig. 1a ist der oszillographisch aufgenommene Verlauf der zwischen den Elektroden 2a und 2b gemessenen Spannung zu sehen. In diesem Fall wird die Einwirkzeit in Abhängigkeit von einem fest vorgegebenen Programm gesteuert. Das bedeutet, die Anzahl der Halbwellen zwischen je einer Ausblendung einer Halbwelle ist konstant. Die Ausblendung erfolgt vom Nulldurchgang der Spannung an während einer ganzen Halbwelle.

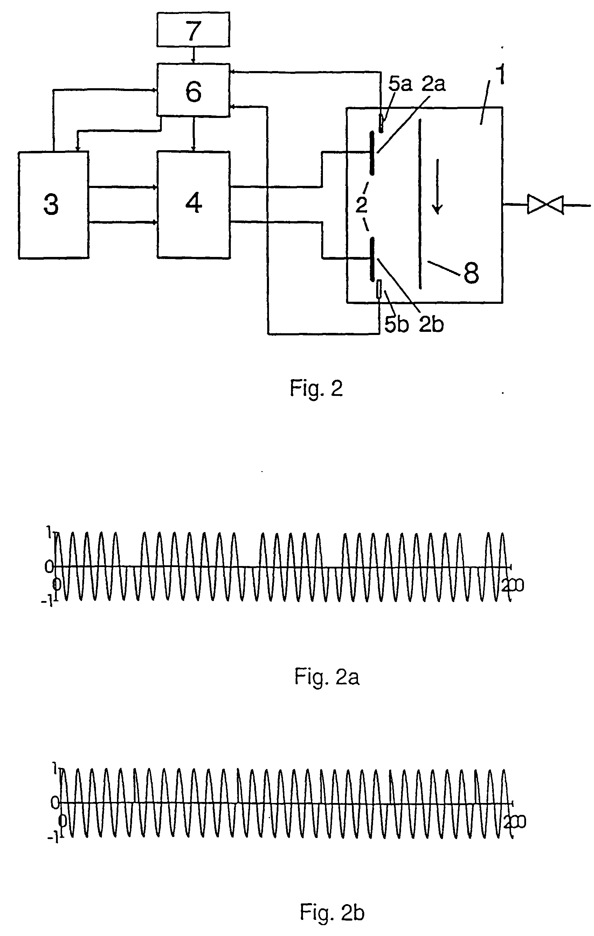

In Fig. 2 ist eine Einrichtung dargestellt, die nach dem gleichen Prinzip aufgebaut ist und arbeitet, aber zum Beschichten ebener Substrate 9 verwendet wird. Die Substrate 9 sollen durch Magnetronsputtern mit Aluminiumoxid beschichtet werden. Die Glimmeinrichtung 2 mit ihren zwei Elektroden bzw. Targets 2a; 2b aus Aluminium werden von dem Sinusgenerator 3 gespeist und wirken wechselweise als Anode bzw. Katode. In der Vakuumkammer 1 befindet sich ein Argon-Sauerstoff-Gemisch bei einem Druck von ca. 0,005 mbar. Der Sinusgenerator 3 hat eine Nennleistung von 70 kW und arbeitet in einem Frequenzbereich von 40 bis 150 kHz. Grundvoraussetzung für gute Schichteigenschaften ist, daß die Zerstäubungsrate der Elektroden 2a; 2b gleich ist. Die Sputterrate wird mit Hilfe der Sensoren 5a und 5b detektiert. Die Meßwerte der Sensoren 5a und 5b werden der Steuereinheit 6 zugeführt. Die Steuereinheit 6 vergleicht diesen Wert mit der Sollwertvorgabe 7 und steuert den Sinusgenerator 3 durch Veränderung der Gesamtleistung und beim Nulldurchgang der Sinusschwingung die Schalteinheit 4 so, daß sich für beide Elektroden 2a; 2b die gleiche Zerstäubungsrate ergibt. In Abhängigkeit vom vorhandenen Argon-Sauerstoff-Gemisch ergab sich für die Schalteinheit für die positive Halbwelle eine Schaltfrequenz im Bereich zwischen 4 kHz und 25 kHz.

Fig. 2a zeigt den aufgenommenen oszillographischen Verlauf der Spannung zwischen den beiden Elektroden 2a; 2b beim Abschalten vollständiger Halbwellen. Die Einwirkzeit ist abhängig von den Meßwerten der Sputterrate, die von den Sensoren 5a; 5b abgenommen werden. Dadurch ist die Anzahl der Halbwellen zwischen je einer Ausblendung einer Halbwelle unterschiedlich. Die Steuerung ist prozeßbezogen und es wird jeweils eine ganze Halbwelle von Nulldurchgang zu Nulldurchgang ausgeblendet.
Im Gegensatz dazu ist in Fig. 2b dargestellt, daß die Halbwelle beim Nulldurchgang unterbrochen wird und die Zuschaltung vor dem nächsten Nulldurchgang erfolgt. Das hat den Vorteil des schnelleren Reagierens, aber den Nachteil des Entstehens von Spannungsspitzen.

## Patentansprüche

1. Verfahren zur Durchführung von Glimmprozessen bei niederem Druck durch Anlegen von einer in einem Generator erzeugten Wechselspannung an zwei Elektroden, so daß die Energie dem Glimmprozeß in Form von positiven und negativen Halbwellen zugeführt wird, wobei der Generator derart gesteuert wird, daß mindestens für die Zeit eines Teiles einer negativen und/oder positiven Halbwelle dem Plasma keine Energie zugeführt wird, und die über die Elektroden dem Glimmprozess zugeführte Energie unterschiedlich ist, **dadurch gekennzeichnet**, daß die Zuführung der Energie durch Abschalten oder Kurzschließen des Generators beim Phasennulldurchgang der Spannung oder des Stromes unterbrochen wird.

2. Verfahren nach Anspruch 1, **dadurch gekennzeichnet**, daß die Energiezuführung mit einer Taktfrequenz, die kleiner ist als die Frequenz der Wechselspannung, gesteuert wird.

3. Verfahren nach Anspruch 1 und 2, **dadurch gekennzeichnet**, daß die dem Glimmprozeß zugeführte Energie für die positiven und/oder negativen Halbwellen nach einem festen, vorgegebenen Programm gesteuert wird.

4. Verfahren nach Anspruch 1 und 2, **dadurch gekennzeichnet**, daß die dem Glimmprozeß zugeführte Energie für die positiven und/oder negativen Halbwellen von einem Prozeßsignal, vorzugsweise mittels der optischen Emission des Plasmas, gesteuert wird.

5. Verfahren nach Anspruch 1 bis 4, **dadurch gekennzeichnet**, daß die Energie des Generators (3) während der Zeit des Nichtwirkens am Glimmprozeß einem Zusatzverbraucher zugeführt wird.

6. Verfahren nach Anspruch 1 bis 4, **dadurch gekennzeichnet**, daß die Elektroden der Glimmeinrichtung während der Zeit des Nichteinwirkens am Glimmprozeß kurzgeschlossen werden.

7. Verfahren nach Anspruch 3, **dadurch gekennzeichnet**, daß durch ein Programm die jeweils eingebrachte mittlere Leistung, der mittlere Strom oder die mittlere Spannung, die durch die positiven und/oder negativen Halbwellen in den Prozeß eingebracht werden, vorgegeben wird.

8. Verfahren nach Anspruch 4, **dadurch gekennzeichnet**, daß das Prozeßsignal mittels der in-situ gemessenen Beschichtungsrate beim Beschichtungsprozeß bzw. Abtragsrate beim Ätzprozeß gewonnen wird.

## Claims

1. Method for carrying out glow processes at low pressure by applying alernating voltage, which is produced in a generator, to two electrodes so that the energy is supplied to the glow process in the form of positive and negative half-waves, the generator being operated in such a manner that, at least for the time of a part of a negative and/or positive half-wave, no energy is supplied to the plasma and the energy supplied to the glow process via the electrodes varying, **characterised in that** the supply of energy is interrupted by switching off or short-circuiting the generator during phase zero-crossing of the voltage or the current.

2. Method according to Claim 1, **characterised in that** the energy supply is controlled by a cycle frequency which is smaller than the frequency of the alternating voltage.

3. Method according to Claim 1 and 2, **characterised in that** the energy supplied to the glow process for the positive and/or negative half-waves is controlled according to a fixed preset programme.

4. Method according to Claim 1 and 2, **characterised in that** the energy supplied to the glow process for the positive and/or negative half-waves is controlled by a process signal, preferably by means of the optical emission of the plasma.

5. Method according to Claim 1 to 4, **characterised in that** the energy of the generator (3) is supplied to a supplementary consumer during the non-operative time in the glow process.

6. Method according to Claim 1 to 4, **characterised in that** the electrodes of the glow device are short-circuited during the non-operational time in the glow process.

7. Method according to Claim 3, **characterised in that** by means of a programme, the respectively supplied average power, the average current or the average voltage, which are brought into the process by the posivite and/or negative half-waves, is preset.

8. Method according to Claim 4, **characterised in that** the process signal is obtained by means of the coating rate measured in situ during the coating process or by means of the stripping rate during the etching process.

## Revendications

1. Procédé pour mettre en oeuvre un processus de décharge par effluves à basse pression en appliquant à deux électrodes une tension alternative produite par un générateur, de telle sorte que l'énergie soit fournie au processus de décharge par effluves sous la forme de demi-ondes positives et de demi ondes négatives, que le générateur soit commandé de telle façon qu'au moins pendant le temps d'une partie d'une demi onde négative et/ou d'une demi-onde positive, il ne soit pas fourni d'énergie au plasma, et que l'énergie amenée par l'intermédiaire des électrodes au processus de décharge par effluves, soit différente,
caractérisé en ce que
l'amenée de l'énergie est interrompue en débranchant ou en court-circuitant le générateur lors du passage par zéro de la tension ou de l'intensité.

2. Procédé selon la revendication 1,
caractérisé en ce que
l'amenée de l'énergie est commandée avec une fréquence de cycles qui est plus petite que la fréquence de la tension alternative.

3. Procédé selon la revendication 1 et 2,
caractérisé en ce que
l'énergie qui est amenée au processus de décharge par effluves pour les demi ondes positives et/ou négatives est commandée selon un programme fixe, prédéfini.

4. Procédé selon la revendication 1 et 2,
caractérisé en ce que
l'énergie qui est amenée au processus de décharge par effluves pour les demi-ondes positives et/ou négatives est commandée par un signal de processus, de préférence au moyen de l'émission optique du plasma .

5. Procédé selon la revendication 1 à 4,
caractérisé en ce que
l'énergie du générateur (3) est envoyée, pendant le temps de non action du processus de décharge par effluves, à un appareil utilisateur additionnel.

6. Procédé selon la revendication 1 à 4,
caractérisé en ce que
les électrodes du système de décharge par effluves sont court-circuitées pendant le temps de non action du processus de décharge par effluves

7. Procédé selon la revendication 3,
caractérisé en ce que
l'on définit au préalable, par un programme la puissance moyenne, l'intensité moyenne ou la tension moyenne respectivement appliquées qui sont mises en oeuvre dans le processus par les demi-ondes positives et/ou négatives.

8. Procédé selon la revendication 4,
caractérisé en ce que
le signal du processus est obtenu au moyen du taux de revêtement mesuré un situ lors du processus de revêtement ou du taux d'érosion lors du processus de gravure.
